Europäisches Patentamt

European Patent Office

Office européen des brevets

(11) Publication number: **0 169 020**
**B1**

# EUROPEAN PATENT SPECIFICATION

(45) Date of publication of patent specification: 26.10.88

(51) Int. Cl.⁴: **C 23 C 14/48,** H 01 L 21/265

(21) Application number: **85304901.3**

(22) Date of filing: **09.07.85**

(54) A process for ion implantation activation in a compound semiconductor crystal.

(30) Priority: **12.07.84 US 630056**

(43) Date of publication of application:
**22.01.86 Bulletin 86/04**

(45) Publication of the grant of the patent:
**26.10.88 Bulletin 88/43**

(84) Designated Contracting States:
**DE FR GB**

(56) References cited:
**EP-A-0 111 085**
**US-A-4 312 681**
**US-A-4 383 869**

PATENT ABSTRACTS OF JAPAN, unexamined
applications, E field, vol. 5, no. 30, February 24,
1981 THE PATENT OFFICE JAPANESE
GOVERNMENT page 135 E 47

APPLIED PHYSICS LETTERS, vol. 38, no. 8,
April 15, 1981 J.M. WOODALL, H. RUPPRECHT
AND R.J. CHICOTKA "Proximate capless
annealing of GaAs using a controlled-excess as
vapor pressure source" page 639—641

PATENT ABSTRACTS OF JAPAN, unexamined
applications, E section, vol. 136, November 10,
1977 THE PATENT OFFICE JAPANESE
GOVERNMENT page 6537 E 77

(73) Proprietor: **International Business Machines**
**Corporation**
**Old Orchard Road**
**Armonk, N.Y. 10504 (US)**

(72) Inventor: **Hovel, Harold John**
**Diane Court**
**Katonah New York 10536 (US)**
Inventor: **Kuech, Thomas Francis**
**43 Cedar Lane**
**Ossining New York 10562 (US)**

(74) Representative: **Hobbs, Francis John**
**IBM United Kingdom Limited Intellectual**
**Property Department Hursley Park**
**Winchester Hampshire SO21 2JN (GB)**

Courier Press, Leamington Spa, England.

## Description

This invention relates to a process for ion implantation activation in a compound semiconductor crystal.

Multielement compound semiconductor materials have electro-optical and carrier transport properties useful in semiconductor devices. However, the multielement crystal responds to the effects of such processing operations as heating in ways that not only affect the location of impurities, but also the stoichiometry of the crystal. Where the crystal surface undergoing processing is a relatively broad area, such as is the case where an integrated circuit is being produced, the conditions must be uniform over the entire surface area in order to assure a yield of uniform devices.

One technique of introducing semiconductor property imparting impurities into such multielement compound semiconductor crystals is known as ion implantation. This technique has the advantages of precision positioning, and in the vicinity of room temperature processing; but the technique also requires a subsequent annealing step at high temperatures which is necessary to repair crystal damage and to activate the implanted impurities.

With large scale integration of circuits, the surface area becomes larger and ion implantation activation annealing can result in non-uniformity, the major reason being localized loss of the ingredients of the multielement compound semiconductor material.

There have been some efforts to control the problem of maintaining uniformity over a multielement compound semiconductor surface when an ion implantation annealing step is employed.

For instance, the tendency of the multielement compound semiconductor GaAs to decompose in processing has received some attention in the art. One technique which has been employed to prevent decomposition is to apply a capping layer, such as $SiO_2$ over the crystal surface. This technique is suggested in US—A—4,226,667.

Another technique suggested in U.S.—A—3,969,164, involves the use of a native oxide of the GaAs.

The art has been mainly directed to control of surface stoichiometry. For instance, in U.S.—A—4,135,952 an effort is made to keep GaAs from decomposing during ion implantation annealing by placing the GaAs crystal surface in proximity with a GaAs crystal in a Ga solution. The desirability of having an excess of the more volatile element of the GaAs is suggested in U.S.—A—4,312,681 wherein InAs is used as a source of excess arsenic to prevent decomposition. The processes suggested in U.S.—A—4,135,952 and 4,312,681 require a standard long, about 30 minute, annealing step.

In Appl. Phys. Lett. *38*, 815 April 1981, page 639, detrimental effects of diffusion of certain substrate impurities in the material GaAs during long annealing steps is recognized and high excess As pressure from InAs is employed for control.

Processes which employ gallium arsenide wafers as a substrate for the ion implanted gallium arsenide samples are quite beneficial in that they provide a clean, well-controlled source of excess arsenic at the interface between the two. However, equal amounts of arsenic leave the substrate and the implanted wafer facing down upon the substrate, such that the excess arsenic benefit is only a factor of 2 which has inherent limits with respect to control of the annealing process.

In addition, EP—A—0 111 085 discloses the ion implantation impurity activation in a multielement compound semiconductor crystal such as gallium arsenide over a broad integrated circuit device area using a short time anneal in the proximity of a uniform concentration of the most volatile element of the crystal in solid form over the broad integrated circuit device area surface. For instance, a gallium arsenide integrated circuit wafer having ion implanted impurities in the surface for an integrated circuit is annealed at temperatures of about 800°C to about 900°C for a time of the order of about 1 to about 20 seconds in the proximity of a uniform layer of solid arsenic.

The solid, most volatile element becomes a uniform controlled gas source during the annealing step used to activate the ion implanted impurities permitting a short, of the order of a few seconds, conventional temperature, annealing step.

In addition, EP—A—108,910 discloses an arrangement for providing the solid arsenic source on a wafer of gallium arsenide by a photoetch technique.

The present invention provides a process for ion implantation activation in a multielement compound semiconductor crystal comprising: implanting semiconductor property imparting impurities through a device area surface of said crystal; placing a major surface of a member in contact with said device area surface of said crystal; said member containing the most volatile element of said multielement compound; and annealing the combination of said member and said crystal while confining the vaporization product of said member to said surface; the process being characterised by said major surfaces being sufficiently rough that its actual area is at least four times as great as its projected area. The annealing is preferably a short elevated temperature cycle anneal.

The surface of the member can contain the most volatile element and/or be covered with a layer containing the most volatile element.

The quantity of the most volatile component of the multiple element compound such as As in contact uniformly all over the surface of the future circuit area of the implanted wafer when vaporized during the anneal cycle prevents erosion of the elements of the multielement compound (e.g., As and Ga), inhibits concentration changes of the most volatile element (e.g.,

As) by diffusion, provides excess vapor pressure of the most volatile element (e.g., As) to drive implanted dopants (e.g., Group IV materials) onto donor site.

How the invention can be carried out will now be described by way of example, with reference to the accompanying drawings, in which:—

Figure 1 is a flow chart illustrating steps in a process embodying the invention; and

Figures 2—4 are schematic diagrams of suitable ion implantation sources.

In order to facilitate explanation of the present invention, the description will be focused on the particular multielement compound semiconductor material gallium arsenide (GaAs). However, the present invention is suitable for the processing of other multiple element compound semiconductor materials such as InP, GaAlAs, and GaInAs.

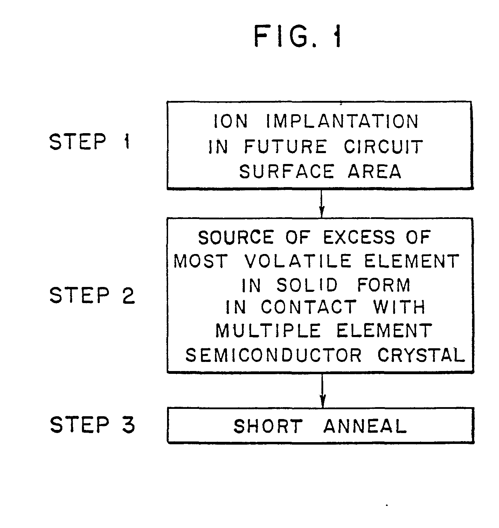

Referring to Figure 1, a flow diagram is provided wherein in Step 1, a multiple element compound semiconductor crystal substrate is implanted with semiconductor property imparting ions in the portion of the crystal that is to be the area of the future integrated circuit. The depth and extent of implantation will vary with the properties being imparted. For instance, silicon ions are introduced by ion bombardment into a crystal GaAs device wafer at energies of about 50 to about 200 kiloelectron volts (KeV) at fluences of about $10^{12}$ to about $10^{14}$ ions per square centimeter and a depth of about 100 nm to about 400 nm.

Other commonly employed n-type dopants are Se, Ge and S. Examples of p-type dopants are Zn, Mn, Mg, Cd, and Be. The implantation energies and fluences vary somewhat depending upon the dopant and the application, but are generally similar to those discussed herein above.

In Step 2, the substrate is positioned with the future device area in contact with ion implantation annealing source to provide the uniform, yet controlled, quantity of excess of the most volatile element over the entire surface of the substrate.

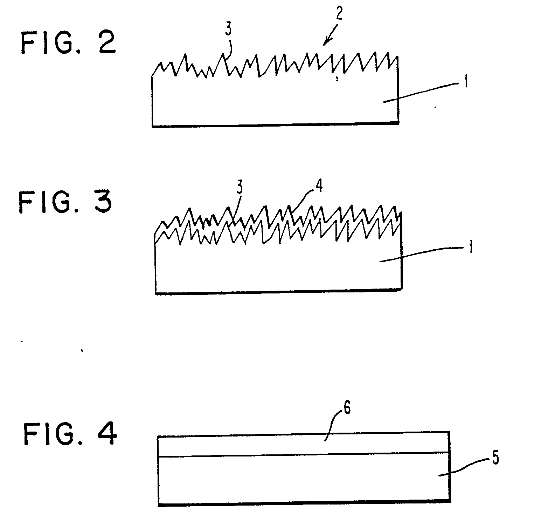

Reference to Figure 2 illustrates one type of ion implantation annealing source 1. This ion implantation annealing source 1, has a rough surface 2 with peaks 3 and valleys and contains the most volatile element of the multielement semiconductor. The number and size of the peaks and valleys is such that the actual surface area of the annealing source is at least about 4 times and most preferably about 4 to about 10 times the projected surface area of the source.

Accordingly, an increase of about 4 to about 10 times the amount of excess of the most volatile element such as the As, as compared to the annealing source used and described in EP—A—0 111 085, is obtained.

The source 1 may be a compound semiconductor such as GaAs or InAs used to supply excess As to an implanted GaAs wafer during the annealing. The availability of excess As obtained is greater than would be obtained using a flat or smooth GaAs or InAs source by the ratio of the increased surface area.

Reference to Figure 3 illustrates the source 1 having an added extra coating of the most volatile element 4 which further increases the quantity of excess volatile element available.

Illustrative of a suitable source is a gallium arsenide or indium arsenide substrate having peaks and valleys, e.g. a dendritic surface, and having a quantity of the most volatile element of the multielement semiconductor such as the arsenic impregnated within the surface of the substrate or having a layer coated. Preferably, the amount of the most volatile element of the multielement semiconductor provided on the substrate is the maximum amount that could be present. This provides for the greatest benefits.

The gallium arsenide or indium arsenide substrate can be roughened by anisotropic etching of a smooth gallium arsenide or indium arsenide surface. An example of a suitable technique is etching the substrate in potassium hydroxide at about 300°C to about 400°C for about 10 to about 30 minutes. Other techniques, particularly for gallium arsenide, are described in Journal of the Electrochemical Society, Vol. 130, p. 2427, December 1983.

A dendritic GaAs or InAs surface can be obtained by the vapor growth of 10—15 µm thick GaAs or InAs layers by metal organic chemical vapor deposition at high rates such as 1—3 µm per minute and at temperatures of 600°C to 700°C. A dendritic surface can also be produced by the vapor growth of aluminium arsenide layers on gallium arsenide or germanium substrates at 600°C to 800°C at rates of 0.5 to 3 µm per minute.

Moreover, if desired, the substrate acting as the source of excess volatile element such as arsenic can be other than the gallium arsenide or indium arsenide and includes such substrates as silicon including polycrystalline silicon and amorphous silicon, silicon dioxide, aluminium oxide, germanium, and metals such as tungsten.

Layers of GaAs, InAs, or AlAs can be deposited on the desired substrate by chemical vapor deposition as described above. Layers of excess As can also be deposited on the desired substrate.

The most volatile element of the multielement component such as the arsenic can be provided onto the substrate by evaporation, sputtering, or vapor deposition techniques. Layers of about 0.1 to about 1 µm thick are preferred.

Referring to Figure 4, there is illustrated another example of an As-rich source for annealing purposes. A layer of amorphous or polycrystalline silicon 6 is deposited by chemical vapor deposition or plasma-assisted chemical vapor deposition upon a suitable substrate 5 which may be Si, $SiO_2$, $Al_2O_3$, or tungsten. The layer is deposited in an atmosphere of an As-containing species such as arsine ($AsH_3$), and a high quantity of As is contained in the layer. Polycrystalline silicon can contain as much as 6—7% As while amorphous Si can contain as much as 10—20%. When in contact with the implanted wafer and heated, the poly or amorphous Si emits As to supply the desired excess As vapor. The substrate 5 could be processed to produce a layer 6 with a rough surface as 2 in Figure 2.

As described in EP—A—0 111 085, the ion-implantation annealing source can include a recess in the backing so that the edges of the backing contact the device area surface and confine the volatile element vapor in a limited controlled volume.

In the third step of Figure 1, the short time, conventional temperature, annealing step takes place. The extent of the annealing step will be relative to the depth and extent of the implantation but, compared with conventional processes, greater annealing control, longer cycles, and greater simplicity is achieved.

The short-time annealing usually takes place for about 2 seconds to about 20 seconds at temperatures between about 900°C and 1100°C.

While the sources of excess arsenic described hereinabove are particularly useful for short-time annealing processes, they are also advantageous as sources of excess arsenic in conventional furnace anneals. For example, gallium arsenide or indium arsenide substrates with roughened surfaces and arsenic-containing polycrystalline or amorphous silicon release arsenic atoms over a considerable period of time, allowing them to be used in longer time anneals as well as short time anneals. Such longer time anneals are generally at temperatures of about 800°C to 850°C for periods of about 10 to 20 minutes.

## Claims

1. A process for ion implantation activation in a multielement compound semiconductor crystal comprising:
implanting semiconductor property imparting impurities through a device area surface of said crystal;
placing a major surface of a member in contact with said device area surface of said crystal, said member containing the most volatile element of said multielement compound; and
annealing the combination of said member and said crystal while confining the vaporization product of said member to said surface, the process being characterised by said major surface of the member being sufficiently rough that its actual surface area is at least four times as great as its projected area.

2. A process as claimed in claim 1, wherein said member comprises indium arsenide, aluminium arsenide or gallium arsenide.

3. A process as claimed in claim 1, wherein said member comprises a substrate coated with one or more layers which contain the most volatile element of said crystal.

4. A process as claimed in claim 3, wherein said substrate comprises silicon, silicon dioxide, aluminium oxide, germanium, tungsten, gallium arsenide, or indium arsenide.

5. A process as claimed in claim 3 or claim 4, wherein said layers containing the most volatile element of said crystal are comprised of indium arsenide, gallium arsenide, aluminium arsenide, arsenic, polycrystalline silicon, or amorphous silicon.

6. A process as claimed in any of claims 3 to 5, wherein said most volatile element is present in a layer of about 0.1 to about 1 µm thick.

7. A process as claimed in any preceding claim, which comprises implanting silicon ions into a gallium arsenide crystal at energies of about 50 to about 200 kiloelectron volts at fluences of about $10^{12}$ to about $10^{14}$ ions per square centimeter and to a depth of about 100 nm to about 400 nm.

8. A process as claimed in any preceding claim, which comprises annealing for about 2 to about 20 seconds at temperatures of about 900°C to about 1100°C.

## Patentansprüche

1. Verfahren zur Ionenimplantationsaktivierung in einem aus vielen Elementen zusammengesetzten Halbleiterkristall, wobei
Verunreinigungen der Halbleitercharakteristik durch die Oberfläche des Bauelementbereichs des Kristalls implantiert werden;
eine Hauptfläche eines Teiles mit der Oberfläche des Bauelementbereiches des Kristalls in Kontakt gebracht wird, wobei dieses Teil das flüchtigste Element der aus vielen Elementen bestehenden Zusammensetzung enthält; und
die Kombination aus dem Teil und dem Kristall vergütet wird, während das Verdampfungsprodukt des Teils auf die Fläche begrenzt wird, dadurch gekennzeichnet, daß die Hauptfläche des Teils genügend rauh ist, so daß sein tatsächlicher Oberflächenbereich mindestens vier mal so groß ist wie seine Projektionsfläche.

2. Verfahren nach Anspruch 1, dadurch gekennzeichnet, daß das Teil Indiumarsenid, Aluminiumarsenid oder Galliumarsenid enthält.

3. Verfahren nach Anspruch 1, dadurch gekennzeichnet, daß das Teil ein Substrat enthält, welches mit einer oder mehreren Schichten überzogen ist, die das flüchtigste Element des Kristalls aufweisen.

4. Verfahren nach Anspruch 3, dadurch gekennzeichnet, daß das Substrat Silizium, Siliziumdioxid, Aluminiumoxid, Germanium, Wolfram, Galliumarsenid oder Indiumarsenid enthält.

5. Verfahren nach Anspruch 3 oder 4, dadurch gekennzeichnet, daß die Schichten mit dem flüchtigsten Element des Kristalls aus Indiumarsenid, Galliumarsenid, Aluminiumarsenid, Arsen, polykristallinem Silizium oder amorphem Silizium bestehen.

6. Verfahren nach einem der Ansprüche 3 bis 5, dadurch gekennzeichnet, daß sich das flüchtigste Element in einer Schicht von ca. 0,1 bis ca. 1 µm Dicke befindet.

7. Verfahren nach einem der vorhergehenden Ansprüche, dadurch gekennzeichnet, daß Siliziumionen in einen Galliumarsenid-Kristall bei Energien von ca. 50 bis ca. 200 keV bei Fluenzen von ca. $10^{12}$ bis ca. $10^{14}$ Ionen pro cm$^2$ und bei einer Tiefe von ca. 100 nm bis ca. 400 nm implantiert werden.

8. Verfahren nach einem der vorhergehenden Ansprüche, dadurch gekennzeichnet, daß die Vergütung ca. 2 bis ca. 20 Sekunden lang bei Temperaturen von ca. 900°C bis ca. 1100°C stattfindet.

## Revendications

1. Procédé pour l'activation par implantation ionique dans un cristal composé semiconducteur à éléments multiples comprenant:

l'implantation d'impuretés conférant des propriétés semiconductrices à travers une surface de région de dispositif de ce cristal;

la mise en contact d'une surface importante d'un corps avec cette surface de région de dispositif du cristal, ce corps contenant l'élément le plus volatil du composé à éléments multiples; et

le recuit de la combinaison de ce corps et de ce cristal tout en limitant le produit de la vaporisation du corps à la surface, le procédé étant caractérisé en ce que cette surface principale est suffisamment grossière pour que sa superficie réelle soit au moins quatre fois plus grande que sa superficie en projection.

2. Procédé suivant la revendication 1, dans lequel le corps contient de l'arséniure d'indium, de l'arséniure d'aluminium ou de l'arséniure de gallium.

3. Procédé suivant la revendication 1, dans lequel le corps comprend un substrat recouvert d'une ou plusieurs couches qui contiennent l'élément le plus volatil du cristal.

4. Procédé suivant la revendication 3, dans lequel le substrat comprend du silicium, de la silice, de l'alumine, du germanium, du tungstène, de l'arséniure de gallium ou de l'arséniure d'indium. ›

5. Procédé suivant la revendication 3 ou la revendication 4, dans lequel les couches contenant l'élément le plus volatil du cristal sont composées d'arséniure d'indium, d'arséniure de gallium, d'arséniure d'aluminium, d'arsenic, de silicium polycristallin ou de silicium amorphe.

6. Procédé suivant l'une quelconque des revendications 3 à 5, dans lequel l'élément le plus volatil est présent dans une couche d'environ 0,1 à environ 1 μm d'épaisseur.

7. Procédé suivant l'une quelconque des revendications précédentes, comprenant l'implantation d'ions silicium dans un cristal d'arséniure de gallium à des énergies d'environ 50 à environ 200 kiloélectronvolts à des fluences d'environ $10^{12}$ à environ $10^{14}$ ions par centimètre carré, et à un profondeur d'environ 100 nm à 400 nm.

8. Procédé suivant l'une quelconque des revendications précédentes, comprenant le recuit pendant environ 2 à environ 20 secondes à des températures d'environ 900°C à environ 1 100°C.

# FIG. 1

STEP 1

> ION IMPLANTATION
> IN FUTURE CIRCUIT
> SURFACE AREA

STEP 2

> SOURCE OF EXCESS OF
> MOST VOLATILE ELEMENT
> IN SOLID FORM
> IN CONTACT WITH
> MULTIPLE ELEMENT
> SEMICONDUCTOR CRYSTAL

STEP 3

> SHORT ANNEAL

FIG. 2

FIG. 3

FIG. 4